# EUROPEAN PATENT APPLICATION

(11) **EP 2 372 798 A1**
(43) Date of publication of application: **05.10.2011**
(21) Application number: 10015149.7
(22) Date of filing: 30.11.2010
(51) Int. Cl.: H01L 33/60

(54) **Substrate for light-emitting element and light-emitting device employing it**

(30) Priority: 31.03.2010 JP 2010082645
(71) Applicant: ASAHI GLASS COMPANY, LIMITED, Chiyoda-ku, Tokyo 100-8405 (JP)
(72) Inventor: Nakayama, Katsuyoshi, Tokyo 100-8405 (JP)
(74) Representative: Müller-Boré & Partner Patentanwälte

(57) **Abstract**

Provided is a substrate for light-emitting element, which has a simple structure and nevertheless is capable of obtaining a high light extraction efficiency when a light-emitting element is mounted thereon.

A substrate for light-emitting element, which comprises a substantially flat-form base member made of a sintered product of a first glass ceramics composition comprising a glass powder and a ceramics filler, and a frame member bonded on an upper main surface of the base member, wherein a concave is formed to have a bottom surface constituted by a part of the upper main surface of the base member and a side surface constituted by an inner wall surface of the frame member, so that the bottom surface of the concave has a mounting portion for mounting a light-emitting element, and the frame member is made of a sintered product of a second glass ceramics composition comprising a glass powder and a ceramics filler, which has a diffuse reflectivity.

## Description

The present invention relates to a substrate for mounting a light-emitting element and a light-emitting device employing it.

In recent years, along with a tendency to high brightness and whitening of a light-emitting diode element, a light-emitting device employing a light-emitting diode element has been used for backlights of mobile phones or liquid crystal TVs, liquid crystal display, etc. However, along with a tendency to high brightness of a light-emitting diode element, heat generation is also increasing, and the temperature increases excessively, whereby adequate emission brightness has not necessarily been obtainable. Therefore, as a substrate for light-emitting element capable of mounting a light-emitting element such as a light-emitting diode element, one capable of readily dissipating heat generated from the light-emitting element and capable of obtaining sufficient emission brightness, has been desired. Heretofore, as a substrate for a light-emitting element, an alumina substrate has, for example, been used. However, the thermal conductivity of the alumina substrate is not necessarily high at a level of from about 15 to 20W/m·K. Accordingly, it is also studied to employ an aluminum nitride substrate having a higher thermal conductivity.

However, the aluminum nitride substrate has drawbacks such that the cost of raw materials is high, and it is hardly sintered, whereby high temperature firing will be required, thus leading to an increase in the process cost. Further, the thermal expansion coefficient of the aluminum nitride substrate is as small as 4×10⁻⁶ to 5×10⁻⁶/°C, and when it is mounted on a printed substrate having a thermal expansion coefficient of at least 9×10⁻⁶/°C as a universal product, adequate connection reliability cannot necessarily be obtainable due to the difference in the thermal expansion.

In order to solve such problems, it has been studied to employ a low temperature co-fired ceramics substrate (hereinafter referred to as a LTCC substrate) as the substrate for light-emitting element. The LTCC substrate comprises, for example, glass and an alumina filler; the difference in their refractive indices is large; and their interfaces are many; and the thickness is larger than the wavelength to be used, whereby a high reflectance can be obtained. It is thereby possible to efficiently utilize light from the light-emitting element, and as a result, it is possible to reduce the quantity of heat generation. Further, it is composed of inorganic oxides which are less susceptible to deterioration by a light source, whereby a constant color can be maintained over a long period of time.

The LTCC substrate is characterized in that as a substrate for light-emitting element, it has a high reflectance as described above, but for the purpose of reflecting light emitted from the light-emitting element in a forward direction as far as possible, it has been attempted to provide a silver reflection film on the surface of the LTCC substrate and provide an overcoat glass on the surface of such a silver reflection film to prevent oxidation or sulfurization. Further as a form of a substrate for light-emitting element, there is a form wherein the substrate has a cavity so that a light-emitting element is to be mounted on the bottom surface of the cavity. However, in such a substrate for light-emitting element, in order to extract light more efficiently, the above-mentioned silver reflection film and overcoat glass structure are also applied to the side surface in addition to the bottom surface of the cavity, in many cases. Further, in such a case, usually in consideration of the reflection properties of the reflection film, the wall of the cavity is made to be upwardly broadened in a tapered shape.

However, in a ceramics substrate, it is rather difficult to form a cavity having a tapered side surface so that the reflection film functions sufficiently, and therefore, as a substitute therefor, for example, Patent Document 1 proposes a technology of a light-emitting element-accommodating package made of ceramics, wherein the side surface of a cavity is formed to be stepwise, and a metal layer is provided on the stepwise surface. However, the technology of the Patent Document 1 had a problem that the structure is complicated, and the number of production steps increases, and a construction of a LTCC substrate for light-emitting element which is excellent in light extraction efficiency with a simple structure, has been desired.

Further, in a light-emitting device wherein a plurality of light-emitting elements are mounted in the above cavity, there has been a problem such that the light extraction efficiency deteriorates as light emitted from a certain light-emitting element enters to its adjacent light-emitting element. To solve such a problem, for example, in Patent Document 2, an attempt has been made to increase the light extraction efficiency in a reflector having a light-emitting element-mounting portion in a concave container made of e.g. a plastic by preventing adsorption of light emitted from a light-emitting element by another light-emitting element by forming a partition wall, preferably a partition wall having a V-form cross section, between the light-emitting elements. However, if it is attempted to form a partition wall having a V-form cross section on a LTCC substrate, the same problem as formation of the above-mentioned tapered side surface will result.
Patent Document 1: JP-A-2006-303351
Patent Document 2: JP-A-2004-517465

The present invention has been made to solve the above-described problems, and it is an object of the present invention to provide a substrate for light-emitting element, which has a simple structure and nevertheless is capable of obtaining a high light extraction efficiency when a light-emitting element is mounted thereon. Further, it is another object of the present invention to provide a light-emitting device with a high emission brightness employing the above substrate for light-emitting element.

The substrate for light-emitting element of the present invention comprises a substantially flat-form base member made of a sintered product of a first glass ceramics composition comprising a glass powder and a ceramics filler, and a frame member bonded on an upper main surface of the base member, wherein a concave is formed to have a bottom surface constituted by a part of the upper main surface of the base member and a side surface constituted by an inner wall surface of the frame member, so that the bottom surface of the concave has a mounting portion for mounting a light-emitting element, and the frame member is made of a sintered product of a second glass ceramics composition comprising a glass powder and a ceramics filler, which has a diffuse reflectivity.

In the substrate for light-emitting element of the present invention, the side surface of the above concave is provided preferably to be substantially perpendicular to the bottom surface of the concave.

Further, in the substrate for light-emitting element of the present invention, it is preferred that in addition to the above frame member, the above base member is also made of a sintered product of a second glass ceramics composition comprising a glass powder and a ceramics filler, which has a diffuse reflectivity.

The ceramics filler in the sintered product of the second glass ceramics composition comprising a glass powder and a ceramics filler, which has a diffuse reflectivity, is preferably a mixture of an alumina powder and a zirconia powder.

In the substrate for light-emitting element of the present invention, the frame member is preferably bonded on the upper main surface of the base member so that the distance between the side surface of the concave and the edge of the mounting portion on the bottom surface of the concave is substantially equal along the entire periphery of the mounting portion.

In a case where the substrate for light-emitting element of the present invention is a substrate for light-emitting element to mount a plurality of light-emitting elements, the frame member is preferably designed in such a shape as to form the above concave independently for every light-emitting element to be mounted. In such a case, the height of the frame member located between the adjacent mounting portions for the light-emitting elements is preferably at least the same height as the highest portion of the light-emitting elements when such light-emitting elements are mounted, and at most a height having 50 µm added to said same height.

The light-emitting device of the present invention comprises the above substrate for light-emitting element of the present invention and a light-emitting element mounted thereon.

By the substrate for light-emitting element of the present invention, despite its simple structure, it is possible to efficiently reflect light emitted in a direction other than the light extraction direction from a mounted light-emitting element to the light extraction direction at the substrate surface. Further, according to the present invention, by mounting a light-emitting element on such a substrate for light-emitting element, it is possible to obtain a light-emitting device whereby a sufficient emission brightness can be obtained.
Fig. 1 is a plan view and cross-sectional view illustrating an example of the first embodiment of the substrate for light-emitting element of the present invention.
Fig. 2 is a plan view and cross-sectional view illustrating another example of the first embodiment of the substrate for light-emitting element of the present invention.
Fig. 3 is a plan view and cross-sectional view illustrating an example of the light-emitting device of the present invention employing the substrate for light-emitting element shown in Fig. 1.
Fig. 4 is views schematically illustrating a part (step (A)) of steps for producing the substrate for light-emitting element shown in Fig. 2.
Fig. 5 is views schematically illustrating parts (step (B) and step (C)) of the steps for producing the substrate for light-emitting element shown in Fig. 2.
Fig. 6 is a plan view and cross-sectional view illustrating an example of the second embodiment of the substrate for light-emitting element of the present invention.
Fig. 7 is a plan view and cross-sectional view illustrating an example of the light-emitting device of the present invention employing the substrate for light-emitting element shown in Fig. 6.
Fig. 8 is views schematically illustrating a part (step (A)') of steps for producing the substrate for light-emitting element shown in Fig. 6.
Fig. 9 is views schematically illustrating parts (step (B)' and step (C)') of the steps for producing the substrate for light-emitting element shown in Fig. 6.

Now, the embodiments of the present invention will be described with reference to the drawings. However, it should be understood that the present invention is by no means restricted by the following description.

The substrate for light-emitting element of the present invention is a substrate for light-emitting element, which comprises a substantially flat-form base member made of a sintered product of a first glass ceramics composition comprising a glass powder and a ceramics filler, and a frame member bonded on an upper main surface of the base member, wherein a concave is formed to have a bottom surface constituted by a part of the upper main surface of the base member and a side surface constituted by an inner wall surface of the frame member, so that the bottom surface of the concave has a mounting portion for mounting a light-emitting element, and the frame member is made of a sintered product of a second glass ceramics composition comprising a glass powder and a ceramics filler, which has a diffuse reflectivity.

According to the present invention, a concave of a LTCC substrate for light-emitting element is constituted by the base member and the frame member so that a light-emitting element can be mounted on the bottom surface of the concave, and as the material constituting the frame member for forming the side surface of the concave, a sintered product (LTCC) of a glass ceramics composition comprising a glass powder and a ceramics filler, which has a diffuse reflectivity, is used, whereby it becomes possible to efficiently lead light emitted from the light-emitting element and irradiated to the side surface of the concave to a light extraction direction by the diffuse reflection. Heretofore, in a substrate for light-emitting element to mount a light-emitting element on the bottom surface of a concave, the side surface of the concave is processed in a tapered form expanded towards the opening, and further on the side surface, a reflection film such as silver is provided, to increase the light extraction efficiency. Whereas, in the present invention, by using a LTCC material having a diffuse reflectivity for the material itself to form the side surface of the concave, without necessity for processing into a tapered form or provision of a silver reflection film or the like, sufficient light reflection in the light extraction direction is made possible only by providing a wall substantially perpendicular to the bottom surface of the concave on which a light-emitting element is mounted. It is thereby possible to obtain a sufficient emission brightness when a light-emitting element is mounted on this substrate for light-emitting element.

In this specification, "substantially perpendicular" is meant for a level where "perpendicular" is felt by a visual level, and likewise, an expression with "substantially" is meant for a level where such is felt by a visual level, unless otherwise specified.

Further, according to the present invention, in a LTCC substrate for light-emitting element to mount a plurality of light-emitting elements, the concave having a bottom surface constituted by a part of the upper main surface of the base member and a side surface constituted by an inner wall surface of the frame member, is formed independently for every light-emitting element, and a LTCC material having a diffuse reflectivity is used for the frame member to constitute the side surface of the concave, whereby with respect to the light emitted from each individual light-emitting element, the light extraction efficiency can be increased in the same manner as described above. It is thereby possible to improve the emission brightness of the emission device as a whole.

In the substrate for light-emitting element of the present invention, the bottom surface of the concave is constituted by the LTCC material having a diffuse reflectivity, whereby it becomes possible to efficiently carry out light reflection in the same manner as described above without providing a silver reflection film or the like. However, depending upon the design of the light-emitting device, the LTCC substrate for light-emitting element may sometimes be required to be provided with a heat dissipation layer, and a heat dissipation layer of e.g. silver may be provided on the surface of the base member main surface including the bottom surface of the concave. In such a case, such a layer may be utilized as a reflection layer, and from the viewpoint of the reflectivity, it is not required to form the bottom surface by the LTCC material having a diffuse reflectivity. However, if the LTCC material constituting the base member is the same material as the LTCC material constituting the frame member, it is possible to prevent a deformation due to a difference in the heat shrinkage, and there is a merit such that the adhesion can be secured. Accordingly, in such a case, depending upon the required properties, the LTCC material to be used for the base member may suitably be selected from one having the same diffuse reflectivity as the frame member or one other than such a material.

Further, in a substrate for light-emitting element having such a construction that a heat dissipation layer is provided within the base member, it is very effective to employ a LTCC material having a diffuse reflectivity for at least the surface layer portion constituting the bottom surface of the concave, with a view to increasing the light extraction efficiency. Further, also in such a case, by selecting the LTCC material constituting the frame member to be the same material as the LTCC material constituting the base member, it is possible to prevent deformation due to a difference in the heat shrinkage, and there is also a merit such that the adhesion can be secured.

With respect to the substrate for light-emitting element of the present invention, the first embodiment of the present invention to mount one light-emitting element, and the second embodiment of the present invention to mount a plurality of light-emitting elements, will be described below.

### <First embodiment>

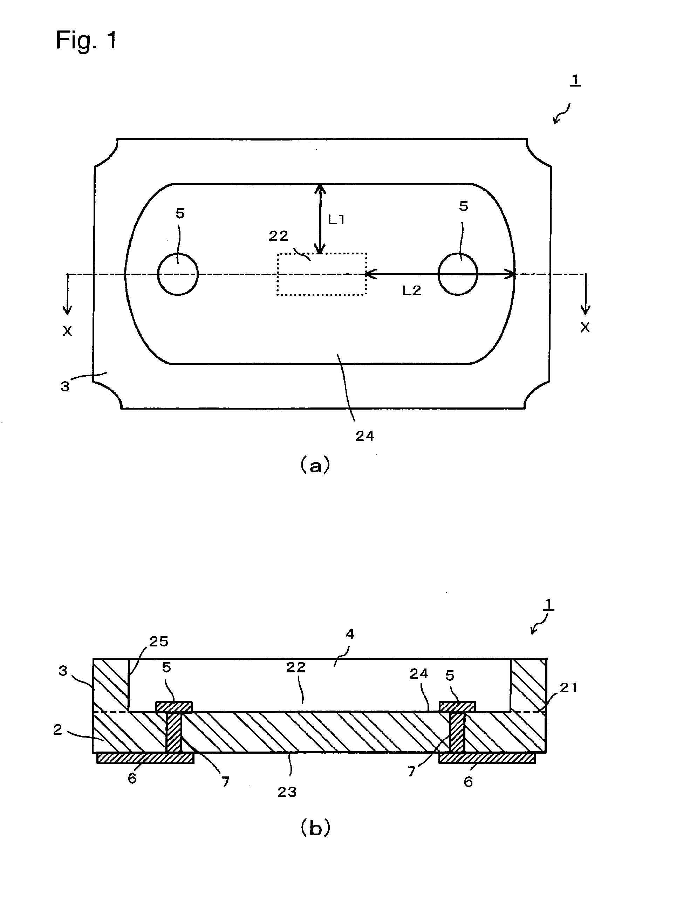

Fig. 1 is a plan view (a) illustrating an example of the substrate 1 for light-emitting element to mount one light-emitting element as the first embodiment of the present invention, and a cross-sectional view (b) along its X-X line.

The substrate 1 for light-emitting element has a substantially flat-form base member having a substantially rectangular shape as viewed from above and mainly constituting the substrate. The base member 2 has the upper side surface as the main surface 21 on which a light-emitting element is to be mounted when used as a substrate for light-emitting element, and in this example, the opposite side surface is regarded as a rear surface 23. The substrate 1 for light-emitting element further has a frame member 3 bonded along the periphery of the main surface 21 of the base member to constitute a concave 4 having a bottom surface 24 constituted by a substantially rectangular portion at the center of the main surface 21 of the base member 2. Here, the side surface 25 of this concave 4 is constituted by an inside wall surface of the frame member 3. In the substrate 1 for light-emitting element, the substantially center portion of the bottom surface 24 of the concave constitutes the mounting portion 22 on which a light-emitting element is to be mounted.

Here, the side surface 25 of the concave 4 is provided to be substantially perpendicular to the bottom surface 24. That is, the frame member 3 is formed so that the opening portion at the top and bottom would have the same shape and bonded to the periphery of the main surface 21 of the base member. Further, in the substrate 1 for light-emitting element, the mounting portion 22 for a light-emitting element is located substantially at the center portion of the bottom surface 24 of the concave, and the distance between the side surface 25 of the concave 4 constituted by the inner wall surface of the frame member 3 and the edge of the light-emitting element-mounting portion 22 is preferably substantially equal along the entire periphery of the mounting portion 22. Here, the substantially equal distance specifically means that when the maximum value among distances between the side surface 25 of the concave 4 and the edge of the light-emitting element-mounting portion 22 on the bottom surface 24 of the concave, over the entire periphery of the mounting portion 22 is represented by L2 (as represented by L2 in Fig. 1 (a)), and the minimum value is represented by L1 (as represented by L1 in Fig. 1 (a)), the value represented by L2/L1 is at most 2. In the substrate for light-emitting element of the present invention, this value represented by L2/L1 is more preferably at most 1.5, most preferably 1.0.

A specific numerical value of the distance between the side surface 25 of the above concave 4 and the edge of the light-emitting element-mounting portion 22 depends on e.g. the electric power or size of the light-emitting element to be mounted and may further depends on e.g. the type or content of a phosphor which may be used, as the case requires, for example, as incorporated in a sealing layer which will be described hereinafter, the conversion efficiency, etc., but, for example, the distance where light emitted from the light-emitting element can be most efficiently emitted in the light extraction direction may be used as an index. More specifically, in a case where a light-emitting element with an electric power of 0.15 W is used at 35 mA, the above distance is preferably within a range of from 100 to 1,200 µm. In such a case, with respect to the maximum value L2 and the minimum value L1, it is preferred to provide the frame member 3 so that both L2 and L1 fall within such a preferred range of the distance, while maintaining the above relation.

Further, the height of the side surface 25 of the concave 4, i.e. the distance (the height of the frame member 3) from the bottom surface 24 of the concave 4 to the maximum height of the frame member 3 is not particularly limited so long as it is a height whereby light from the light-emitting element mounted can be sufficiently reflected in the light extraction direction. Specifically, it is preferably higher by from100 to 500 µm than the height of the highest portion of the light-emitting element when the light-emitting element is mounted, from the viewpoint of e.g. efficiently filling a sealing material containing a phosphor to change the wavelength or shape of the product on which the light-emitting device is mounted, although it depends also on the design of the light-emitting device, such as the electric power of the light-emitting element to be mounted, the distance from the edge of the light-emitting element-mounting portion, etc. Further, the height of the frame member 3 is more preferably at most the height having 450 µm added to the height of the highest portion of the light-emitting element, further preferably at most the height having 400 µm added thereto.

Further, in the case of a substrate for light-emitting element to mount a plurality of light-emitting elements, it is further preferred that the height of the frame member located between the mounting portions of the light-emitting elements is made to be at least the same height as the highest portion of the light-emitting elements and at most the height having 50 µm added to such a height.

In this example, both the base member 2 and the frame member 3 are constituted by a sintered product (LTCC) of a glass ceramics composition comprising a glass powder and a ceramics filler, which has a diffuse reflectivity. In the light-emitting element-mounting substrate of this example, by constituting the base member 2 and frame member 3 having the above structures by LTCC having a diffuse reflectivity, it is possible to obtain a light-emitting device with high brightness, whereby when a light-emitting element is mounted, the bottom surface 24 of the concave 4 and the side surface 25 sufficiently reflect light emitted from a light-emitting element in the light extraction direction.

LTCC having a diffuse reflectivity to be used for the substrate for light-emitting element of the present invention is not particularly limited so long as it is one whereby the light extraction efficiency is improved in a light-emitting device employing it as the substrate material, preferably one whereby the light extraction efficiency corresponding to a silver reflection film is obtainable. However, when a haze value measured by JIS K7105 is employed as an index to evaluate the diffuse reflectivity, the value is preferably at least 95%, more preferably at least 98%.

Such a sintered product of a glass ceramics composition comprising a glass powder and a ceramics filler having a diffuse reflectivity, may, for example, be a sintered product obtainable by adding a binder and, as the case requires, a plasticizer, a dispersant, a solvent, etc. to the following glass ceramics composition comprising a glass powder and a ceramics filler, to prepare a slurry, forming the slurry into a sheet having a prescribed shape by e.g. a doctor blade method, followed by drying, and as the case requires, by binder burn out, and firing it at a temperature of from 800°C to 930°C.

### (Glass ceramics composition)

The glass powder is not necessarily limited, but one having a glass transition point (Tg) of from 550°C to 700°C is preferred. If the glass transition point (Tg) is lower than 550°C, binder burn out is likely to be difficult, and if it exceeds 700°C, the shrinkage start temperature tends to be high so that the dimension precision is likely to deteriorate.

Further, it is preferred that when it is fired at a temperature of from 800°C to 930°C, crystals will precipitate. In the case of one whereby no crystals will precipitate, it is likely that no adequate mechanical strength can be obtained. Further, one having a crystallization peak temperature (Tc) of at most 880°C as measured by DTA (differential thermal analysis) is preferred. If the crystallization peak temperature (Tc) exceeds 880°C, the dimensional precision is likely to deteriorate.

As such a glass powder, preferred is, for example, one comprising from 57 mol% to 65 mol% of SiO₂, from 13 mol% to 18 mol% of B₂O₃, from 9 mol% to 23 mol% of CaO, from 3 mol% to 8 mol% of Al₂O₃, and from 0.5 mol% to 6 mol% in total of at least one member selected from K₂O and Na₂O. By using such a glass powder, it becomes easy to improve the planarity of the surface of the obtainable sintered product.

Here, SiO₂ will be a network former of glass. If the content of SiO₂ is less than 57 mol%, it tends to be difficult to obtain stabilized glass, and the chemical durability is likely to deteriorate. On the other hand, if the content of SiO₂ exceeds 65 mol%, the glass melting temperature or the glass transition point (Tg) tends to be too high. The content of SiO₂ is preferably at least 58 mol%, more preferably at least 59 mol%, particularly preferably at least 60 mol%. Further, the content of SiO₂ is preferably at most 64 mol%, more preferably at most 63 mol%.

B₂O₃ will be a network former of glass. If the content of B₂O₃ is less than 13 mol%, the glass melting point or the glass transition point (Tg) is likely to be too high. On the other hand, if the content of B₂O₃ exceeds 18 mol%, it tends to be difficult to obtain stable glass, and the chemical durability is also likely to deteriorate. The content of B₂O₃ is preferably at least 14 mol%, more preferably at least 15 mol%. Further, the content of B₂O₃ is preferably at most 17 mol%, more preferably at most 16 mol%.

Al₂O₃ is added in order to increase the stability, chemical durability and strength of glass. If the content of Al₂O₃ is less than 3 mol%, the glass is likely to be unstable. On the other hand, if the content of Al₂O₃ exceeds 8 mol%, the glass melting point or the glass transition point (Tg) is likely to be too high. The content of Al₂O₃ is preferably at least 4 mol%, more preferably at least 5 mol%. Further, the content of Al₂O₃ is preferably at most 7 mol%, more preferably at most 6 mol%.

CaO is added in order to increase the stability of glass or the precipitation property of crystals and to lower the glass melting temperature or the glass transition point (Tg). If the content of CaO is less than 9 mol%, the glass melting point is likely to be too high. On the other hand, if the content of CaO exceeds 23 mol%, the glass is likely to be unstable. The content of CaO is preferably at least 12 mol%, more preferably at least 13 mol%, particularly preferably at least 14 mol%. Further, the content of CaO is preferably at most 22 mol%, more preferably at most 21 mol%, particularly preferably at most 20 mol%.

K₂O or Na₂O is added in order to lower the glass transition point (Tg). If the total content of K₂O and Na₂O is less than 0.5 mol%, the glass melting point or the glass transition point (Tg) is likely to be too high. On the other hand, if the total content of K₂O and Na₂O exceeds 6 mol%, the chemical durability, particularly the acid resistance, is likely to deteriorate, and the electrical insulation property is also likely to deteriorate. The total content of K₂O and Na₂O is preferably from 0.8 mol% to 5 mol%.

The glass powder is not necessarily limited to one comprising only the above-described components and may contain other components within a range to satisfy various properties such as the glass transition point (Tg). When it contains such other components, their total content is preferably at most 10 mol%.

The glass powder can be obtained by producing a glass having the above-described glass composition by a melting method and grinding it by a dry grinding method or a wet grinding method. In the case of a wet grinding method, it is preferred to employ water as a solvent. The grinding can be carried out by using a grinding machine such as a roll mill, a ball mill or a jet mill.

The 50% particle size (D₅₀) of the glass powder is preferably from 0.5 µm to 2 µm. If the 50% particle size of the glass powder is less than 0.5 µm, the glass powder is likely to cohere, whereby the handling tends to be difficult, and it tends to be difficult to uniformly disperse it. On the other hand, if the 50% particle size of the glass powder exceeds 2 µm, the glass softening temperature is likely to rise, or the sintering is likely to be inadequate. The particle size can be adjusted, for example, by classification which is carried out after the grinding, as the case requires. In this specification, the particle size is a value obtained by a particle size analyzer of a laser diffraction scattering method. As the particle size analyzer of a laser diffraction scattering method, a laser diffraction particle size analyzer (tradename: SALD2100 manufactured by Shimadzu Corporation) was used.

On the other hand, as the ceramics filler, among ceramics fillers to be commonly used for the production of a LTCC substrate, a mixture of an alumina powder and a zirconia powder is preferably employed. As the mixture of an alumina powder and a zirconia powder, preferred is a mixture wherein the blend ratio of the alumina powder:zirconia powder is from 90:10 to 60:40 by mass ratio. Further, the 50% particle size (D₅₀) of the ceramics filler is preferably e.g. from 0.5 µm to 4 µm.

The above glass powder and the ceramics filler are mixed, for example, within a range of the glass powder:the ceramics filler=30:70 to 50:50 by mass ratio to obtain a glass ceramics composition. To this glass ceramics composition, a binder, and, as the case requires, a plasticizer, a dispersing agent, a solvent, etc. are added to obtain a slurry.

As the binder, for example, a polyvinyl butyral or an acrylic resin may be suitably used. As the plasticizer, for example, dibutyl phthalate, dioctyl phthalate or butylbenzyl phthalate may be employed. Further, as the solvent, an organic solvent such as toluene, xylene, 2-propanol or 2-butanol may suitably be employed.

Further, the base member 2 preferably has a flexural strength of at least 250 MPa with a view to preventing a damage, etc. during the mounting of a light-emitting element and during the subsequent use thereof. However, the LTCC having a diffuse reflectivity constituting the base member 2 and the frame member 3 as described above, usually satisfies such a flexural strength property.

Further, the light-emitting element-mounting portion 22 on the main surface 21 of the base member 2 preferably has a surface planarization to secure the heat dissipation property, and from the viewpoint of efficiency in the production while securing an adequate heat dissipation property, the surface smoothness is preferably at most 0.15 µm, more preferably at most 0.10 µm, as surface roughness Ra. Here, the surface roughness Ra is meant for an arithmetic mean roughness Ra, and the value of an arithmetic mean roughness Ra is one represented by JIS:B0601 (1994) 3 "Definition and Representation of Defined Arithmetic Mean Roughness".

The above LTCC having a diffuse reflectivity as the material constituting the base member 2 is preferably one capable of securing the above surface roughness Ra. Specifically, in the above-described glass ceramics composition for the base member, by prolonging the kneading time in the step for preparing the slurry, the ceramics filler will be ground, so that the surface roughness Ra can be made to be within the above range.

In the substrate 1 for light-emitting element, on the bottom surface 24 of the concave constituted by a part of the main surface 21 of the base member 2, a pair of element connection terminals 5 to be, respectively, electrically connected to a pair of electrodes of a light-emitting element, are provided in a substantially circular shape at the peripheral portion outside the light-emitting element-mounting portion 22, specifically to face against both sides of the mounting portion.

On the rear surface 23 of the base member 2, a pair of external connection terminals 6 are provided which are electrically connected to an exterior circuit, and inside the base member 2, a pair of via conductors 7 are provided which electrically connect the above element-connection terminals 5 and the external connection terminals 6. With respect to the element-connection terminals 5, the exterior connection terminals 6 and the via conductors 7, so long as they are electrically connected in the order of the light-emitting element, the element connection terminals 5, the via conductors 7, the external connection terminals 6 and the external circuit, their disposed positions or shapes are not limited to those shown in Fig. 1 and may be optionally adjusted.

The material to constitute such element connection terminals 5, external connection terminals 6 and via conductors 7 (hereinafter, they may generally be referred to as "wiring conductors") is not particularly limited so long as it is the same constituting material as wiring conductors to be commonly used for a substrate for light-emitting element. The material to constitute such wiring conductors may specifically be a metal material composed mainly of copper, silver, gold or the like. Among such metal materials, a metal material made of silver, silver and platinum, or silver and palladium is preferably employed.

Further, in the element connection terminals 5 or the external connection terminals 6, it is preferred that on a metal conductor layer made of such a metal material and preferably having a thickness of from 5 to 15 µm, an electrically conductive protective layer to protect such a layer from oxidation or sulfurization and having electrical conductivity, is formed. Such an electrically conductive protective layer is not particularly limited so long as it is composed of an electrically conductive material having a function to protect the above metal conductor layer, but a gold-plated layer is preferred, and a nickel/gold-plated layer structure having gold plating applied on nickel plating is more preferred. With respect to the thickness of the electrically conductive protective layer, the nickel-plated layer is preferably from 3 to 20 µm, and the gold-plated layer is preferably from 0.1 to 1.0 µm.

In an example of the substrate 1 for light-emitting element according to the first embodiment of the present invention as shown in Fig. 1, the substrate 1 for light-emitting element has no heat-dissipating means. However, in the present invention, a heat-dissipating means may be provided to the substrate for light-emitting element, as the case requires.

As the heat-dissipating means, a thermal via provided immediately below the mounting portion and/or a heat dissipation layer or the like in parallel with the bottom surface of the concave i.e. the main surface of the base member may, for example, be mentioned, but a method of providing a heat dissipation layer in parallel with the main surface of the base member in the interior of the base member in the vicinity of the main surface of the base member, is preferred from such a viewpoint that the planarity of the mounting portion can easily be secured.

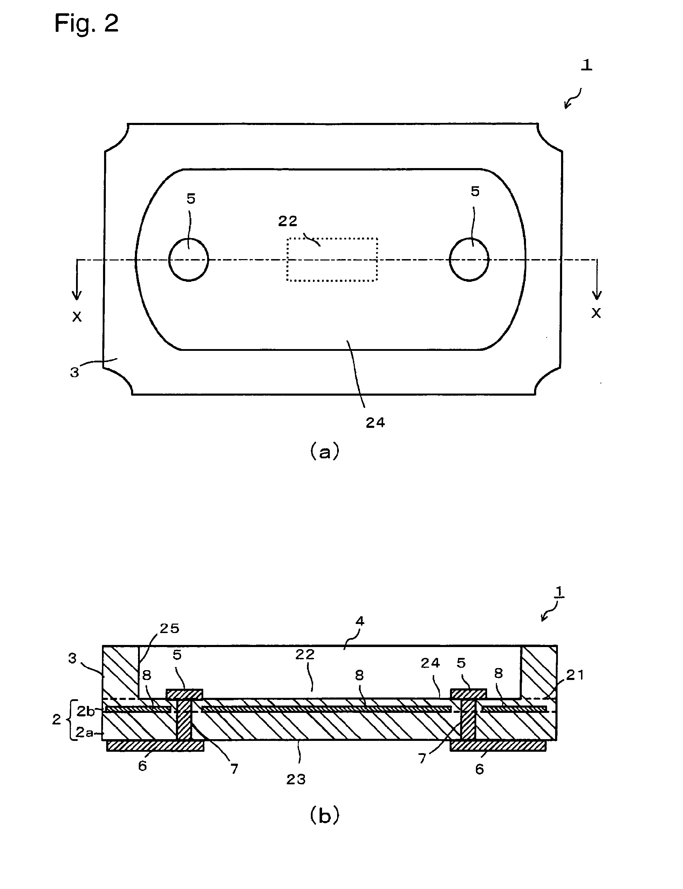

Fig. 2 is a plan view and cross-sectional view illustrating an example of the first embodiment of the substrate for light-emitting element of the present invention having a heat dissipation layer in parallel with the main surface of the base member.

Other than the heat dissipation layer 8 provided in the interior of the base member in the vicinity of the main surface of the base member in parallel with the main surface of the base member, the substrate 1 for light-emitting element shown in Fig. 2 may be entirely the same in construction as the substrate 1 for light-emitting element shown in the above-described Fig. 1.

The heat dissipation layer 8 is provided on a main body 2a mainly constituting the base member 2, as a layer in parallel with the main surface 21 of the base member, so that its surface is located at a position in a depth of preferably from 5 to 150 µm, more preferably from 75 to 125 µm, from the main surface 21 of the base member. The above position where the heat dissipation layer 8 is provided is a position where an adequate insulation protective function is secured by a covering layer 2b formed on the heat dissipation layer to constitute the uppermost portion having the main surface of the base member and which is adjusted in consideration with the economical efficiency, the deformation due to a difference in the thermal expansion from the base member, etc.

In consideration of the heat dissipation property, the heat dissipation layer 8 is preferably provided to have a large area as far as possible, but it is disposed so that its edge stays inside of the base member so that the interlayer adhesion between the covering layer 2b and the main body 2a mainly constituting the base member can be secured. Specifically, it is provided so that the proportion of the area occupied by the heat dissipation layer 8 on the main body 2a will be from 60 to 80% to the area of the region where the heat dissipation layer 8 is not formed other than the periphery in the main body 2a, i.e. to the area of the region other than the via conductors 7 and the vicinity around them. Here, the above proportion of the area occupied by the heat dissipation layer 8 is preferably from 65 to 75%, more preferably from 68 to 72%. Further, via conductors 7 are provided at two portions inside the base member 2, and the heat dissipation layer 8 is provided to maintain a distance of preferably at least 100 µm, more preferably at least 150 µm, from the via conductors 7 as the distance to be electrically insulated, and further in consideration of e.g. a trouble from the production aspect.

Further, the thickness of the heat dissipation layer 8 is preferably from 8 to 50 µm, more preferably from 10 to 20 µm, particularly preferably from 13 to 16 µm. If the thickness of the heat dissipation layer 8 is less than 8 µm, no adequate heat dissipation property is likely to be obtainable, and if it exceeds 50 µm, such is economically disadvantageous, and a deformation due to a difference in thermal expansion from the main body of the substrate in the production process is likely to occur.

The material to constitute the heat dissipation layer 8 is not particularly limited so long as it is a material having heat conductivity, but a metal material which can be co-fired together with the LTCC substrate and containing silver which is excellent also in light reflectivity, may be mentioned as a preferred material. The metal material containing silver may specifically be a metal material composed of silver, silver and platinum, or silver and palladium. The metal material composed of silver and platinum or palladium may specifically be a metal material wherein the proportion of platinum or palladium to the entire amount of the metal material is at most 5 mass%. Among them, a heat dissipation layer composed solely of silver is preferred from such a viewpoint that a high reflectance can be obtained in the present invention.

In order to obtain a sufficient heat dissipation property, the surface of the heat dissipation layer 8 preferably has planarization. As such a surface planarization, specifically, the surface roughness Ra is preferably at most 0.15 µm, more preferably at most 0.1 µm, at least at the light-emitting element-mounting portion 22, from the viewpoint of the production efficiency while securing an adequate heat dissipation property.

Further, the heat dissipation layer 8 may be made to have a multilayer structure, as the case requires, wherein layers different in the constituting material, are laminated.

In the substrate 1 for light-emitting element of the present invention shown in Fig. 2, the heat dissipation layer 8 is disposed in the interior of the base member in the vicinity of the main surface of the base member in parallel with the main surface 21 of the base member, but it may be formed on the main surface 21 of the base member in the same construction as described above. In such a case, it is preferred that a heat dissipation layer having a reflectivity as a heat dissipation property is provided, and to cover this heat dissipation layer, an overcoat glass layer or the like is provided as an insulating property-protective layer.

Such a construction may, for example, be a construction wherein a heat dissipation layer 8 is formed on the bottom surface 24 of the concave constituted by a part of the main surface 21 of the base member of the substrate 1 for light-emitting element shown in Fig. 1, in a form to exclude the portion where the above-mentioned pair of element connection terminals 5 are disposed and the vicinity around it, and further, an overcoat glass layer is formed as an insulation property-protective layer to cover the entirety including the edge of such a heat dissipation layer 8. Here, the edge of the overcoat glass layer may be in contact with the element connection terminals 5, so long as the insulation property of the heat dissipation layer 8 and the element connection terminals 5 provided on the bottom surface 24 of the concave can be secured, but in consideration of a possible trouble in the production, the distance between them is preferably at least 75 µm, more preferably at least 100 µm.

Further, with respect to the distance between the edge of the heat dissipation layer 8 and the edge of the overcoat glass layer covering it, it is preferred that the distance is as short as possible within a range wherein the heat dissipation layer 8 is sufficiently protected from any external deteriorating factors. Specifically, the distance is preferably from 10 to 50 µm, more preferably from 20 to 30 µm. If this distance is less than 10 µm, due to exposure of the heat dissipation layer 8, oxidation, sulfurization or the like of the metal material constituting the heat dissipation layer 8, particularly a metal material containing silver which is preferably employed, is likely to occur, whereby the thermal conductivity/heat dissipation property is likely to deteriorate, and if it exceeds 50 µm, the area of the region on which the heat dissipation layer 8 is disposed will consequently be reduced, whereby the thermal conductivity/heat dissipation property may sometimes deteriorate.

The thickness of the overcoat glass layer is preferably from 5 to 50 µm in consideration of e.g. the economical efficiency, a deformation due to a difference in thermal expansion from the base member, etc. while securing a sufficient insulation-protecting function, although it may depends also on the design of the light-emitting device. In order to obtain a sufficient heat dissipation property, the surface of the overcoat glass layer preferably has a planarity. As such a surface planarity, specifically, the surface roughness Ra is preferably at most 0.03 µm, more preferably at most 0.01 µm, at least at the light-emitting element-mounting portion 22, from the viewpoint of the production efficiency while securing a sufficient heat dissipation property. Further, the raw material composition relating to the overcoat glass film will be described in the after-mentioned process for producing the second embodiment.

When a heat dissipation layer having a sufficient heat dissipation property is provided in parallel with the main surface of the base member in the above-described construction and no thermal via is formed immediately below the light-emitting element-mounting portion, the difference in height between the highest portion and the lowest portion of the surface irregularities at the light-emitting element-mounting portion is equal to the surface other than the mounting portion i.e. the surface of the insulation property-protective layer and is usually at most 0.5 µm. As compared with a method for providing thermal vias which brings about surface irregularities at a level of at most 1 µm at the light-emitting element-mounting portion even by using a special method, the above method for providing a heat dissipation layer in parallel with the main surface of the base member is advantageous in view of the high planarization of the light-emitting element-mounting portion, the heat dissipation property and the bonding property of the light-emitting element.

Here, even when a heat dissipation layer having a sufficient heat dissipation property is provided in parallel with the main surface of the substrate, in a case where the heat dissipation layer having a reflectivity is to be formed on the surface of the main surface of the base member, the base member may not necessarily be made of a sintered product (LTCC) of a glass ceramics composition comprising a glass powder and a ceramics filler having a diffuse reflectivity, as mentioned above.

For example, LTCC for a base member may be prepared by using as a glass powder to be contained in a glass ceramics composition, the same one as the above-mentioned LTCC having a diffuse reflectivity, and has a ceramics filler which has been commonly used for the production of a LTCC substrate, without any particular restriction. In such a case, as the ceramics filler, for example, an alumina powder, a zirconia powder or a mixture of an alumina powder and a zirconia powder may suitably be employed. The 50% particle size (D₅₀) of the ceramics filler is, for example, preferably from 0.5 µm to 4 µm. Such a glass powder and a ceramics filler may be blended and mixed, for example, so that the glass powder would be from 30 mass% to 50 mass%, and the ceramics filler would be from 50 mass% to 70 mass%, to obtain a glass ceramics composition. Further, by adding a binder and, if required, a plasticizer, a dispersing agent, a solvent, etc. to such a glass ceramics composition, a slurry can be obtained.

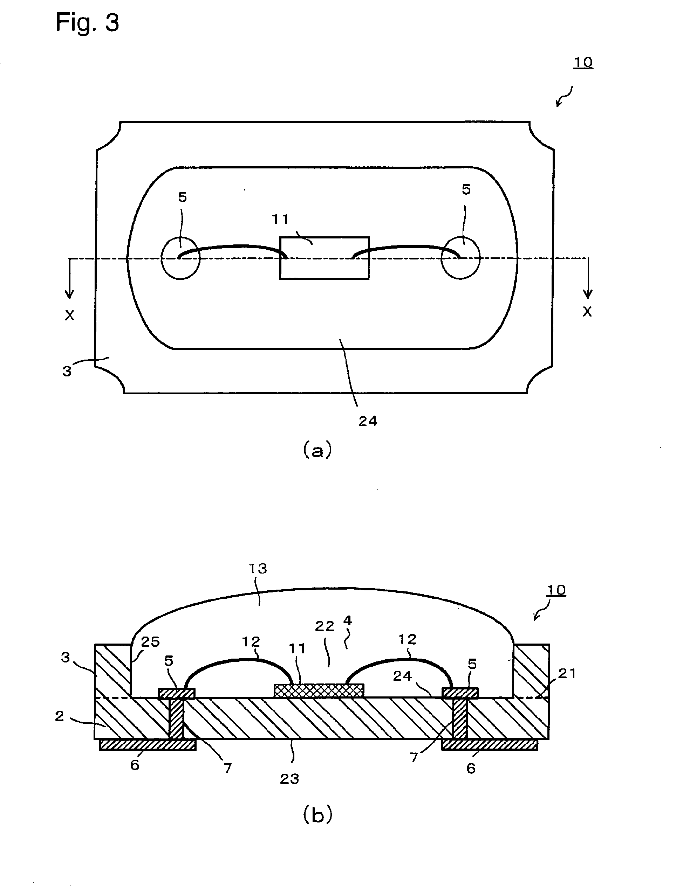

In the foregoing, the substrate for light-emitting element according to the first embodiment of the present invention has been described. For example, by using the substrate 1 for light-emitting element as shown in Fig. 1 and mounting a light-emitting element 11 such as a light-emitting diode element on its mounting portion 22, it is possible to prepare, for example, a light-emitting device 10 as shown in Fig. 3.

As shown in Fig. 3, in the light-emitting device 10, a light-emitting element 11 such as a light-emitting diode element is mounted on the mounting portion 22 of the substrate 1 for light-emitting element by a die bond agent such as a silicone die bond agent, and a pair of electrodes not shown are respectively connected to a pair of element connection terminals 5 by bonding wires 12, and a sealing layer 13 is provided to cover the light-emitting element 11 and the bonding wires 12. Here, the material (sealing material) constituting the sealing layer 13 may contain a phosphor which is commonly used for a sealing layer of a light-emitting device, as the case requires.

Such a light-emitting device 10 according to the first embodiment of the present invention is a light-emitting device capable of obtaining a sufficient emission brightness by employing the substrate for light-emitting element of the present invention which has a simple structure but nevertheless is capable of efficiently reflecting light emitted from the mounted light-emitting element in a direction other than the light extraction direction, at the substrate surface to the light extraction direction.

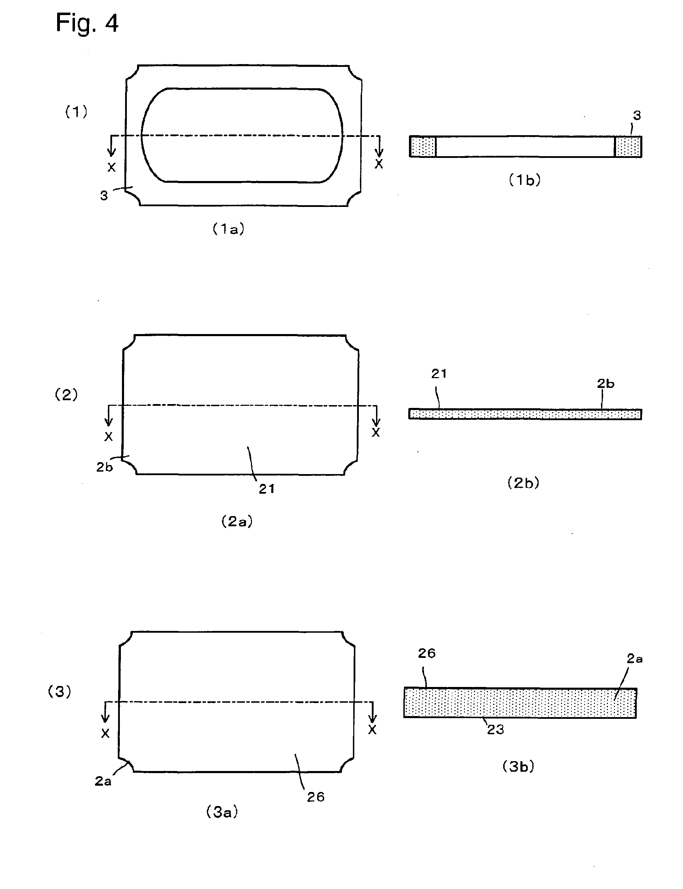

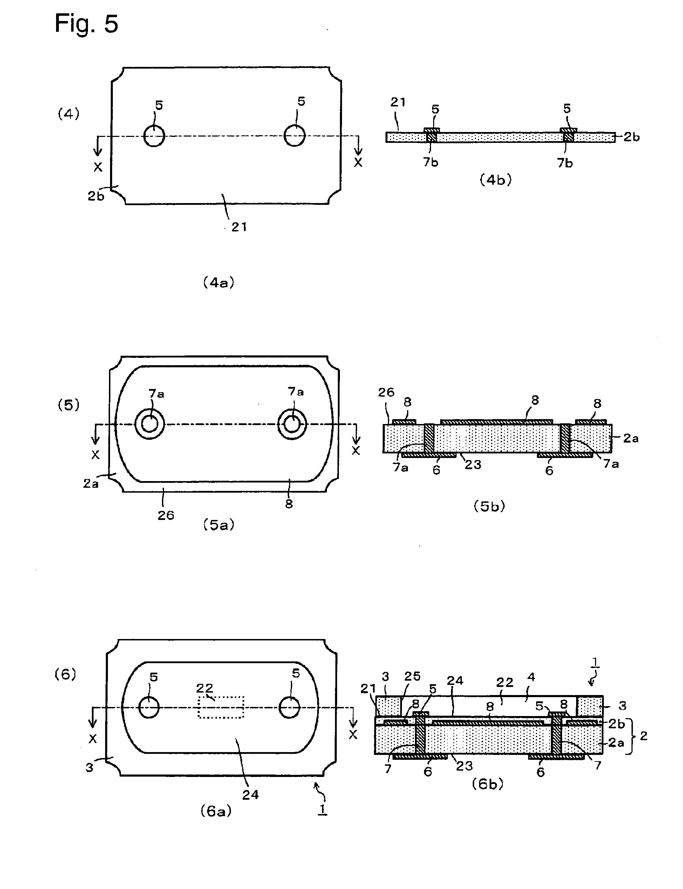

The substrate for light-emitting element according to the first embodiment of the present invention can be produced, for example, by a production process comprising the following steps (A) to (D). Now, taking the substrate 1 for light-emitting element shown in Fig. 2 as an example, the production process will be described with reference to Figs. 4 and 5, and components to be used for the production will be described by attaching the same symbols as for the components in the completed product.

### (A) Step for preparing green sheets

Firstly, the following green sheets (i) to (iii) are prepared by using the glass ceramics composition comprising a glass powder and a ceramics filler for LTCC having a diffuse reflectivity as described above.
(i) A green sheet 3 for frame member constituting the frame member 3 (Fig. 4(1) shows a plan view (1 a) and a cross-sectional view (1 b) along its X-X line)
(ii) A substantially flat plate-form green sheet 2a for main body to constitute the main body 2a of the base member 2, wherein a surface on which a covering layer is to be laminated is a lamination surface 26 and a surface on the opposite side will be the rear surface 23 of the base member 2 (Fig. 4(3) shows a plan view (3a) and a cross-sectional view (3b) along its X-X line)
(iii) A green sheet 2b for covering layer to constitute the covering layer 2b of the base member 2 and having the main surface 21 of the base member 2 (Fig. 4(2) shows a plan view (2a) and a cross-sectional view (2b) along its X-X line)

Each of these green sheets can be produced by preparing a slurry by adding a binder and, as the case requires, a plasticizer, a dispersing agent, a solvent, etc. to the above glass ceramics composition, forming it by e.g. a doctor blade method into a sheet-form having a prescribed shape and thickness so that the shape and thickness after firing will be the above-described desired ranges, followed by drying.

### (B) Step for forming conductive paste layers

Prescribed conductive paste layers are formed at prescribed positions on the green sheet 2a for main body and the green sheet 2b for covering layer obtained in the above step (A). Fig. 5(4) is views showing the green sheet 2b for covering layer after forming conductive paste layers ((4a) is a plan view, and (4b) is a cross-sectional view along its X-X line). In the green sheet 2b for covering layer, via conductor paste layers 7b constituting parts of via conductors 7 are formed at prescribed two positions, and substantially circular-form element connection terminal paste layers 5 are formed to cover the via conductor paste layers 7b at prescribed positions on the surface constituting the main surface 21 of the base member 2.

Fig. 5(5) is views showing the green sheet 2a for main body after forming conductive paste layers ((5a) is a plan view, and (5b) is a cross-sectional view along its X-X line).

In the step for forming conductive paste layers, via conductor paste layers 7a constituting parts of via conductors 7 passing through from the lamination surface 26 to the rear surface 23 are formed at prescribed two positions in the green sheet 2a for main body, and external connection terminal conductor paste layers 6 electrically connected to the via conductor paste layers 7a are formed on the rear surface 23. Further, on the lamination surface 26 of the green sheet 2a for main body, a paste layer 8 for heat dissipation layer containing a material having a thermal conductivity, preferably a metal material containing silver, is formed by screen printing at areas excluding the periphery of the lamination surface 26 of the green sheet 2a for main body and portions where the above pair of via conductors 7a are provided and the vicinity around them.

As a method for forming the element connection terminal paste layers 5, the external connection terminal conductor paste layers 6 and the via conductor paste layers 7 (specifically the via conductor paste layers 7a to be formed in the green sheet 2a for main body and via conductor paste layers 7b to be formed in the green sheet 2b for covering layer), a method of applying and filling a conductive paste by a screen printing method may be mentioned. The thicknesses of the element connection terminal paste layers 5 and the external connection terminal conductor paste layers 6 to be formed are adjusted so that the thicknesses of the finally obtainable element connection terminals and external connection terminals will be prescribed thicknesses.

As the conductor paste, it is possible to use one having a vehicle such as ethylcellulose and, as the case requires, a solvent, etc. added to a metal powder composed mainly of e.g. copper, silver, gold or the like to form a paste. Further, as the above metal powder, a metal powder composed of silver, or a metal powder composed of silver and platinum or palladium, may preferably be employed.

The paste for heat dissipation layer to be used for screen printing to form the heat dissipation layer 8 is a paste containing a material having a thermal conductivity to form the heat dissipation layer 8, preferably a metal material containing silver. As such a material, as mentioned above, silver, a mixture of silver and palladium or a mixture of silver and platinum may, for example, be mentioned. However, for the above-mentioned reason, silver is preferably employed. As the paste for heat dissipation layer, it is possible to employ one having a vehicle such as ethylcellulose and, as the case requires, a solvent, etc. added to a thermal conductive material powder composed mainly of such a material to form a paste. The thickness, area and shape of the paste layer 8 for heat dissipation layer to be formed are adjusted so that the finally obtainable heat dissipation layer 8 will have the above-described desired thickness, area and shape.

Further, in order to bring the surface roughness Ra of the finally obtainable heat dissipation layer 8 to be within the above preferred range, it is preferred to use a powder having a small particle size distribution as the metal powder to be contained in the metal paste.

### (C) Lamination step

On the lamination surface 26 of the green sheet 2a for main body provided with a conductor paste layer, obtained in the above step (B), a green sheet 2b for covering layer provided with a conductive paste layer is laminated so that the surface having the element connection terminal paste layers 5 formed faces upward i.e. the surface to constitute the main surface 21 of the base member 2 faces upward. Further, the green sheet 3 for frame member obtained in the above step (A) is laminated thereon to obtain a non-fired substrate 1 for light-emitting element (Fig. 5(6) shows a plan view (6a) and a cross-sectional view (6b) along its X-X line).

### (D) Firing step

After the above step (C), the obtained non-fired substrate 1 for light-emitting element is subjected to binder burn out to remove the binder, etc., as the case requires and then to firing (firing temperature: 800 to 930°C) to sinter the glass ceramics composition, etc.

The binder burn out can be carried out by holding the substrate, for example, at a temperature of from 500°C to 600°C for from 1 hour to 10 hours. If the binder burn out temperature is lower than 500°C or the binder burn out time is less than 1 hour, the binder, etc. may not sufficiently be removed. On the other hand, when the binder burn out temperature is about 600°C, and the binder burn out time is about 10 hours, the binder, etc. can be sufficiently removed, and if the binder burn out temperature or time exceeds such a level, the productivity, etc. may deteriorate.

Further, the firing can be carried out by suitably adjusting the time within a temperature range of from 800°C to 930°C in consideration of the productivity and securing dense structures of the base member 2 and the frame member 3. Specifically, it is preferred to maintain the substrate at a temperature of from 850°C to 900°C for from 20 minutes to 60 minutes, and particularly preferably, the firing is carried out at a temperature of from 860°C to 880°C. If the firing temperature is lower than 800°C, one having dense structures of the base member 2 and the frame member 3 may not be obtainable. On the other hand, if the firing temperature exceeds 930°C, the productivity, etc. may deteriorate, such that the base member itself undergoes deformation. Further, in a case where a metal paste containing a metal powder composed mainly of silver, is used as the above conductor paste or paste for reflection film, if the firing temperature exceeds 880°C, softening proceeds excessively, and a prescribed shape may not be maintained.

As described above, the non-fired substrate 1 for light-emitting element is fired to obtain a substrate 1 for light-emitting element. After the firing, as the case requires, a conductive protective film to be commonly used for the protection of the conductor in the substrate for light-emitting element, such as gold plating, may be provided to cover the entirety of the element connection terminals 5 and external connection terminals 6.

In the foregoing, the method for producing an example of the substrate for light-emitting element according to the first embodiment of the present invention has been described, but the green sheet 2a for main body, the green sheet 3 for the frame member, or the like may not necessarily be composed of a single green sheet, and may be one having a plurality of green sheets laminated one on another. Further, the sequential order for forming the respective portions may suitably be changed within a range where the production of the substrate for light-emitting element is possible.

### <Second Embodiment>

Now, as the second embodiment of the present invention, a substrate for light-emitting element to mount a plurality of light-emitting elements will be described.

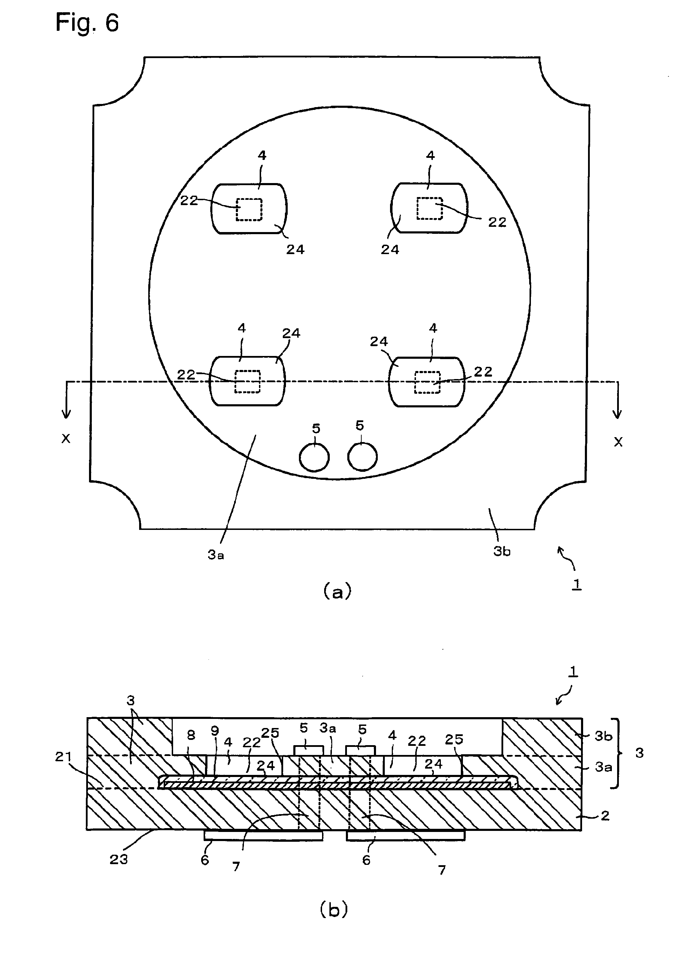

Fig. 6 is a plan view (a) and a cross-sectional view (b) along its X-X line, illustrating an example of the substrate 1 for light-emitting element to mount plural, e.g. four, light-emitting elements as a second embodiment of the present invention.

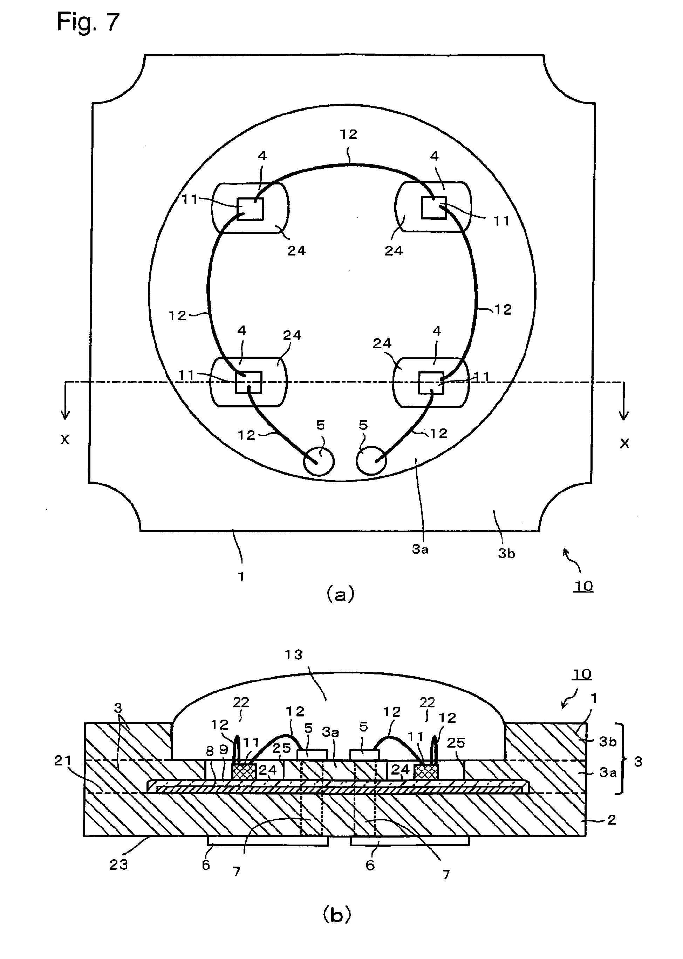

The substrate 1 for light-emitting element according to the second embodiment of the present invention may, for example, be one on which, as shown in Fig. 7, four light-emitting elements 11 are to be mounted so that they are electrically connected in series at substantially circular positions in e.g. a quadrangular shape. In such a substrate 1 for light-emitting element, the light-emitting elements 11 are electrically connected in series by bonding wires 12, and a sealing layer 13 is provided to cover such light-emitting elements 11 and bonding wires 12, so that it can be used as a light-emitting device 10.

Here, the second embodiment of the present invention will be described with reference to a light-emitting device and a substrate for light-emitting device wherein four light-emitting elements 11 are mounted so that they are electrically connected in series. However, the number of light-emitting elements to be mounted or the method for electrical connection such as in series or in parallel in a case where a plurality of elements are mounted, is not particularly limited. Constructions of individual components which will be described below may suitably be adjusted depending upon the design of the light-emitting device to be used within the range of the present invention.

The substrate 1 for light-emitting element has a substantially flat plate-form base member 2 having substantially square shape as observed from above, which mainly constitutes the substrate 1. The base member 2 has an upper side surface as the main surface 21 on which light-emitting elements are mounted when used as a substrate for light-emitting element, and in this embodiment, the surface on the opposite side is a rear surface 23. At a substantially center portion on the main surface 21 of the base member 2, four mounting portions 22 to mount four light-emitting elements are disposed in a substantially ring form in a square shape or the like.

The substrate 1 for light-emitting element has a frame member 3 bonded on the main surface 21 of the base member 2. The frame member 3 is designed in such a shape as to form a concave having a bottom surface 24 constituted by a part of the main surface 21 of the base member 2 and a side surface 25 constituted by a wall surface of the frame member, independently for every mounting portion 22 at the four locations on the main surface of the base member. Specifically, the frame member 3 comprises a substantially flat plate-form lower frame member 3a having a shape as viewed from above being substantially of the same size as the substantially square base member 2 and having four through-holes in e.g. a quadrangular shape substantially circularly so that the mounting portions 22 at the four locations disposed on the main surface 21 of the base member 2 are, respectively, positioned substantially at the centers of the respective through-holes, and a substantially flat plate-form upper frame member 3b bonded to the periphery of the lower frame member 3a having a shape as observed from above being of the same size as the substantially square base member 2 and having a large diameter circular hole substantially at the center portion.

As described above, the substrate 1 for light-emitting element has four concaves 4 each constituted by a bottom surface 24 being a part of the main surface 21 of the base member and a side surface 25 being an inner wall surface of the frame member i.e. the inner wall surface of each of four through-holes of the lower frame member 3a and each having one light-emitting element-mounting portion 22 substantially at the center portion of the bottom surface 24. Here, each of the four concaves 4 has its side surface 25 provided to be substantially perpendicular to the bottom surface 24. That is, each of the through-holes of the lower frame member 3a is formed so that the upper and lower portions of the opening have the same shape, and the lower frame member is bonded to the main surface 21 of the base member at portions other than the through-holes.

Further, in the substrate 1 for light-emitting element, the four light-emitting element-mounting portions 22 are positioned substantially at the center portions of the corresponding respective concave bottom surfaces 24, and the distance between the edge of each light-emitting element-mounting portion 22 and the side surface 25 of each concave 4 constituted by the inner wall surface of each through-hole of the lower frame member 3a is preferably substantially the same along the entire periphery of the mounting portion 22. Here, the substantially equal distance is as described in the above first embodiment, and a preferred distance between the edge of the mounting portion 22 and the side surface 25 is also the same as in the above first embodiment.

Here, in this example as an example of the substrate for light-emitting element to mount a plurality of light-emitting elements, the shape of the frame member 3 to form the four concaves is as described above, but the shape is not particularly limited so long as the distance of the side surface from the edge of the mounting portion 22 is maintained to have a constant distance.

Further, in the substrate 1 for light-emitting element, the height of the lower frame member 3a positioned between the light-emitting element-mounting portions 22 is preferably at least the same height as the highest portion of the light-emitting elements when the light-emitting elements are mounted and at most a height having 50 µm added to such a height, from the viewpoint of the precision in positioning in the step of mounting the light-emitting elements on the mounting portions 22 i.e. in the die-bond step or the operation efficiency of wire bonding.

In the substrate 1 for light-emitting element shown in Fig. 6, the frame member 3 is constituted by a lower frame member 3a to form concaves having the above light-emitting element-mounting portions 22, and an upper frame member 3b formed on the periphery of the base member 2 in a wall form higher by one step from the lower frame member 3a. The height of this upper frame member 3b i.e. the distance from the bottom surface 24 of the concave 4 to the highest position of the upper frame member 3b is not particularly limited so long as it is a height whereby light from the light-emitting elements to be mounted can be sufficiently reflected in the light extraction direction. Specifically, it is preferably higher by from 100 to 500 µm than the height of the highest portion of the light-emitting elements when the light-emitting elements are mounted, from the viewpoint of the shape of the product to mount the light-emitting device, efficiently filling a sealing material containing a phosphor to change the wavelength, etc. although it depends also on the design of the light-emitting device, e.g. the electric power of the light-emitting element to be mounted, the distance from the edge of the above light-emitting element-mounting portions, etc. Here, the height of the frame member 3 is more preferably at most a height having 450 µm added to the height of the highest portion of the light-emitting elements, and further preferably at most a height having 400 µm added to the height of the highest portion of the light-emitting elements.

Further, in the case of a substrate for light-emitting element to mount a plurality of light-emitting elements, it is further preferred that in addition to the above, the height of the frame member positioned between the light-emitting element-mounting portions is made to be at least the same height as the highest portion of the light-emitting elements and at most the height having 50 µm added to such a height.

In this example, at least the frame member 3 (the lower frame member 3a and the upper frame member 3b) is made of a sintered product (LTCC) of a glass ceramics composition comprising a glass powder and a ceramics filler, having a diffuse reflectivity. As LTCC having a diffuse reflectivity, the same one as LTCC having a diffuse reflectivity, employed in the above first embodiment, may be used.

The base member 2 is made of a sintered product of a glass ceramics composition comprising a glass powder and a ceramics filler. In this example, as described hereinafter, on the main surface 21 of the base member 2, a heat dissipation layer 8 serving also as a reflection layer and an overcoat glass layer 9 as an insulating protective layer, are formed, and therefore, LTCC constituting the base member 2 may not necessarily be LTCC having a diffuse reflectivity, as mentioned above, but it is preferred to use the same one as LTCC having a diffuse reflectivity constituting the frame member 3, since it is thereby possible to prevent a deformation due to difference in the thermal shrinkage or the adhesion between the base member 2 and the frame member 3.

In the substrate 1 for light-emitting element of this example, by constituting the frame member 3 having the above structure by LTCC having a diffuse reflectivity, it is possible to obtain a light-emitting device having a high brightness, whereby when light-emitting elements are mounted, light emitted from the light-emitting elements can be reflected sufficiently in the light extraction direction not only at the reflection layer provided at the bottom surface 24 of each concave 4 but also at the side surface 25.

The substrate 1 for light-emitting element of this example may, for example, be used so that, as shown in Fig. 7, four light-emitting elements 11 and a pair of element connection terminals 5 provided on the lower frame member 3a are electrically connected in series by bonding wires 12. When four light-emitting elements are represented by the first light-emitting element, the second light-emitting element, the third light-emitting element and the fourth light-emitting element, and the pair of element connection terminals are represented by the first element connection terminal and the second element connection terminal, they are connected by the bonding wires 12 in the order of the first element connection terminal, the first light-emitting element, the second light-emitting element, the third light-emitting element, the fourth light-emitting element and the second element connection terminal.

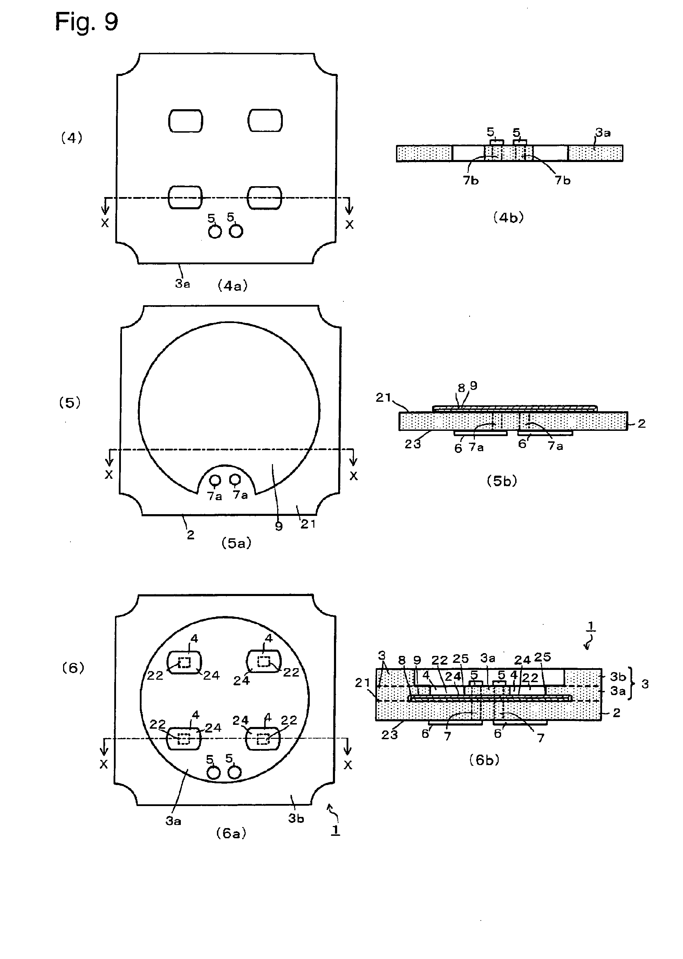

In the substrate 1 for light-emitting element of this example, in order to make the above connection possible, the pair of element connection terminals 5 provided on the lower frame member 3a are formed, for example, as shown in Fig. 6 substantially in a circular form near the boundary with the upper frame member 3b, so that the pair are closely disposed with such a distance as to secure the insulating property. Further, the lower frame member 3a has, immediately below the pair of element connection terminals 5, a pair of via conductors 7b (see Fig. 9(4b)) which are, respectively, electrically connected to the element connection terminals 5.

On the other hand, on the rear surface 23 of the base member 2, a pair of external connection terminals 6 are provided which are electrically connected to an external circuit, and in the interior of the base member 2, a pair of via conductors 7a (see Fig. 9(5b)) are provided which electrically connect the element connection terminals 5 and the via conductors 7b provided in the above lower frame member 3a and the external connection terminals 6 on the above-mentioned rear surface 23 of the base member. Hereinafter, via conductors 7b and the via conductors 7a will be together referred to as via conductors 7.

The constituent materials for such element connection terminals 5, external connection terminals 6 and via conductors 7 i.e. wiring conductors, are not particular limited so long as they are the same constituent materials as for wiring conductors which are commonly used for substrates for light-emitting elements, and they may be the same ones as described as constituent materials to be used for wiring conductors in the above first embodiment. Further, in the same manner as in the above first embodiment, the element connection terminals 5 and the external connection terminals 6 may have a construction having an electrically conductive protective layer such as a gold-plated layer, as the case requires.

Further, with respect to the above element connection terminals 5, external connection terminals 6 and via conductors 7, their positions or shapes are not limited to those shown in Fig. 6 and may suitably be adjusted so long as they are eclectically connected in the order of the light-emitting elements, the element connection terminals 5, the via conductors 7, the external connection terminals 6 and the external circuit.

On the main surface 21 of the base member 2, the heat dissipation layer 8 is formed in such a shape to exclude the periphery of the main surface 21 of the base member and the portions on which the pair of via conductors 7 are provided and the vicinity around them. On the main surface 21 of the base member, further, an overcoat glass layer 9 is formed as an insulating protective layer to cover the entirety including the edge of the above heat dissipation layer 8.

Here, the constituent materials, thicknesses, the surface properties, provided regions, etc. of the heat dissipation layer 8 and the overcoat glass layer 9 may be the same as for the dissipation layer 8 and the overcoat glass layer 9 in the above-described first embodiment.

In the foregoing, the substrate 1 for light-emitting element in accordance with the second embodiment of the present invention has been described, and, for example, by using the substrate 1 for light-emitting element shown in Fig. 6, it is possible to prepare a light-emitting device 10 shown in Fig. 7 by mounting light-emitting elements 11 such as light-emitting diode elements on the mounting portions 22.

As shown in Fig. 7, the light-emitting device 10 is one wherein four light-emitting elements 11 such as light-emitting diode elements are mounted on the above prescribed mounting portions 22 on the substrate 1 for light-emitting element by a die bond agent such as a silicon die bond agent so that they are electrically connected in series by means of bonding wires 12.

Specifically, when the four light-emitting elements 11 are represented by the first light-emitting element, the second light-emitting element, the third light-emitting element and the fourth light-emitting element, and the pair of element connection terminals 5 are represented by the first element connection terminal, and the second element connection terminal, they are connected by bonding wires 12 in the order of the first element connection terminal, the first light-emitting element, the second light-emitting element, the third light-emitting element, the fourth light-emitting element and the second element connection terminal. Further, the light-emitting device 10 is constructed so that a sealing layer 13 is provided to cover the light-emitting elements 11 and the bonding wires 12. The material to constitute the sealing layer 13 (the sealing material) may contain a phosphor which is commonly used for a sealing layer of a light-emitting device, as the case requires.

Such a light-emitting device 10 according to the second embodiment of the present invention is a light-emitting device capable of obtaining a sufficient emission brightness by employing the substrate for light-emitting element of the present invention which has a simple structure but nevertheless is capable of efficiently reflecting light emitted from the mounted light-emitting element in a direction other than the light extraction direction, at the substrate surface to the light extraction direction.

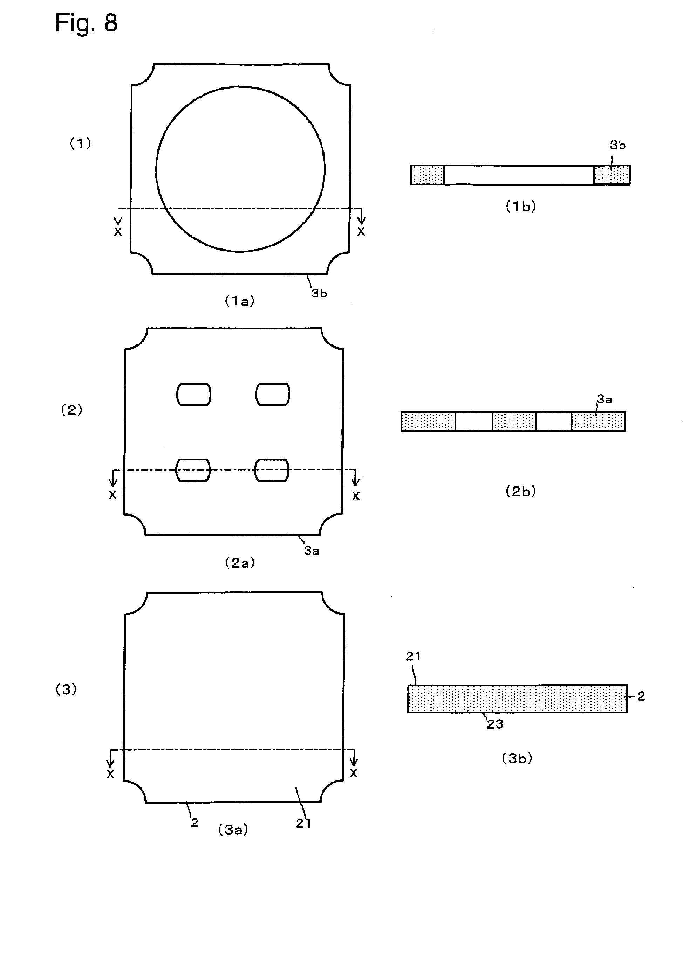

The substrate for light-emitting element according to the second embodiment of the present invention can be produced, for example, by a production process comprising the following steps (A)' to (D)'. Now, taking the substrate 1 for light-emitting element shown in Fig. 6 as an example, the production process will be described with reference to Figs. 8 and 9, with respect to a case where LTCC having a diffuse reflectivity is used as LTCC constituting the base member 2 and the frame member 3. Here, components to be used for the production will be described by attaching the same symbols as for the components in the completed product.

### (A)' Step for preparing green sheets

Firstly, the following green sheets (i) to (iii) are prepared by using the glass ceramics composition comprising a glass powder and a ceramics filler for LTCC having a diffuse reflectivity as described above.
(i) Green sheet 3b for upper frame member to constitute an upper frame member 3b (Fig. 8(1) shows a plan view (1 a) and a cross-sectional view (1 b) along its X-X line)
(ii) Green sheet 3a for lower frame member to constitute a lower frame member 3a (Fig. 8(2) shows a plan view (2a) and a cross-sectional view (2b) along its X-X line)
(iii) Substantially flat plate-form green sheet 2 for base member to constitute a base member 2, having a main surface 21 constituted by the upper surface to mount light-emitting elements of the base member 2 and a rear surface 23 constituted by a surface on the opposite side (Fig. 8(3) shows a plan view (3a) and a cross-sectional view (3b) along its X-X line)

Each of these green sheets can be produced by preparing a slurry by adding a binder and, as the case requires, a plasticizer, a dispersing agent, a solvent, etc. to the above glass ceramics composition, forming it, by e.g. a doctor blade method, into a sheet having a prescribed shape and thickness so that the shape and thickness after firing would be within the above-described desired ranges.

### (B)' Step for forming conductor paste layers and overcoat glass paste layers

Prescribed conductor paste layers are formed at prescribed positions on the green sheet 3a for lower frame member obtained in the above step (A)'. Further, with respect to the green sheet 2 for base member obtained in the above step (A)', the conductive paste layers are formed at prescribed positions, and further prescribed overcoat glass paste layers are formed at prescribed positions.

Fig. 9(4) is a view illustrating the green sheet 3a for lower frame member after forming the conductor paste layers ((4a) is a plan view, and 4(b) is a cross-sectional view along its X-X line). On the green sheet 3a for lower frame member, paste layers 7b for via conductors constituting parts of via conductors 7 are formed at prescribed two locations, and substantially circular element connection terminal paste layers 5 are formed to cover the via conductor paste layers 7b at prescribed positions on the upper surface on the side opposite to the side laminated on the green sheet 2 for base member.

Fig. 9(5) is a view illustrating the green sheet 2 for base member after forming the conductor paste layers and the overcoat glass paste layer ((5a) is a plan view, and 5(b) is a cross-sectional view along its X-X line).

In the step for forming conductor paste layers, via conductor paste layers 7a are formed to constitute parts of via conductors 7 extending from the main surface 21 to the rear surface 23 at prescribed two locations of the green sheet 2 for base member, and on the rear surface 23, external connection terminal conductor paste layers 6 electrically connected to the via conductor paste layers 7a are formed. Further, on the main surface 21 of the green sheet 2 for base member, a paste layer 8 for heat dissipation layer containing a material having a thermal conductivity, preferably a metal material containing silver, is formed by screen printing a region excluding the periphery of the main surface 21 of the green sheet 2 for base member and portions where the above pair of via conductors 7a are provided and the vicinity around them.

Then, an overcoat glass paste layer 9 is formed by screen printing on the main surface 21 of the green sheet for base member to cover the entirety including the edge of the paste layer 8 for the heat dissipation layer present on the main surface 21 of the green sheet for base member excluding the periphery on the main surface 21 of the green sheet 2 for base member and the portions where the above pair of via conductors 7a are provided and the vicinity around them.

As the method for forming the above element connection terminal paste layers 5, external connection terminal conductor paste layers 6 and via conductor paste layers 7 (specifically, via conductor paste layers 7a to be formed in the green sheet 2 for base member and via conductor paste layers 7b to be formed in the green sheet 3a for lower frame member), a method for applying and filling a conductor paste by a screen printing method may be mentioned. The thicknesses of the element connection terminal paste layers 5 and external connection terminal conductor paste layers 6 to be formed, are adjusted so that the thicknesses of the finally obtainable element connection terminals and external connection terminals would be prescribed thicknesses.

With respect to the wiring conductor pastes such as the element connection terminal paste, the via conductor paste, the external connection terminal conductor paste, etc. to be used for forming these conductor paste layers, and a metal paste for the heat dissipation layer, the same ones as described in the above first embodiment may be used, and the forming method may be the same.

Further, the above overcoat glass paste may be one prepared by adding a vehicle such as ethylcellulose and, as the case requires, a solvent, etc. to a glass powder (glass powder for glass film) to form a paste. The thickness of the overcoat glass paste layer 9 to be formed, is adjusted so that the thickness of the finally obtainable overcoat glass layer 9 would be the above-mentioned desired thickness.

The glass powder for the overcoat glass layer may be one whereby a film-form glass is obtainable by firing in the firing step (D)' to be carried out after the following step (C)', and its 50% particle size (D₅₀) is preferably at least 0.5 µm to 2 µm. Further, adjustment of the surface roughness Ra of the overcoat glass layer 9 may be carried out by the particle size of the glass powder for the overcoat glass layer. That is, by using, as the glass powder for overcoat glass layer, one which can be sufficiently melted during firing and is excellent in fluidity and which has a 50% particle size (D₅₀) of the above-mentioned range, it is possible to adjust the surface roughness Ra within the above-mentioned preferred range.

### (C)' Lamination step

On the main surface 21 of the green sheet 2 for base member provided with the conductor paste layers and the overcoat glass paste layer, obtained in the above step (B)', a green sheet 3a for lower frame member provided with conductor paste layers, is laminated with the formed surface up. Further, the green sheet 3b for upper frame member obtained in the above step (A)' is laminated thereon to obtain a non-fired substrate 1 for light-emitting element (Fig. 9(6) shows a plan view (6a) and a cross-sectional view (6b) along its X-X line).

### (D)' Firing step

After the above step (C)', the obtained non-fired substrate 1 for light-emitting element is subjected to binder burn out to remove the binder, etc., as the case requires and then, firing is carried out to sinter the glass ceramics composition, etc. This firing step can be carried out in the same manner as the firing step (D) in the process for producing a substrate for light-emitting element according to the above first embodiment.

In such a manner, the non-fired substrate 1 for light-emitting element is fired to obtain the substrate 1 for light-emitting element, and after the firing, as the case requires, it is possible to provide a conductive protective film which is commonly used for protecting a conductor in a substrate for light-emitting element, such as a gold-plated layer, in order to cover the entirety of the element connection terminals 5 and external connection terminals 6.

In the foregoing, the process for producing the substrate for light-emitting element according to the second embodiment of the present invention has been described, but the green sheet 2 for base member, the green sheet 3a for lower frame member or the green sheet 3b for upper frame member is not necessarily made of a single green sheet and may be one having a plurality of green sheets laminated. Further, the order for forming the respective portions, etc. may also optionally be changed within a range where the production of the substrate for light-emitting element is possible.

In the foregoing, the first embodiment of the present invention to mount one light-emitting element and the second embodiment of the present invention to mount a plurality of light-emitting elements have been described with reference to the respective examples of the substrates for light-emitting elements and light-emitting devices employing them. However, the substrate for light-emitting element and the light-emitting device of the present invention are not limited thereto. Within the range of the concept of the present invention, and as the case requires, their constructions may suitably be changed.

By the substrate for light-emitting element of the present invention, despite its simple structure, it is possible to efficiently reflect light emitted from the mounted light-emitting element in a direction other than the light extraction direction, to the light extraction direction at the substrate surface. Further, according to the present invention, it is possible to provide a light-emitting device capable of emitting light with sufficiently high brightness by employing the substrate for light-emitting element of the present invention with good light extraction efficiency. Such a light-emitting device of the present invention can be suitably used as a backlight for e.g. mobile phones, liquid crystal display, etc., as illumination for automobiles or decorations, or as other light sources.

### EXAMPLES

Now, the present invention will be described in detail with reference to Examples. However, it should be understood that the present invention is by no means restricted to such Examples.

### EXAMPLE 1

By the following process, a light-emitting device for test was prepared wherein one light-emitting element 1 having the same structure as shown in Fig. 3 was mounted. Here, in the same manner as above, the same symbols are used for the components before and after the firing.

Firstly, a green sheet 2 for base member and a green sheet 3 for frame member were prepared to prepare the base member 2 and the frame member 3 for the substrate 1 for light-emitting element. For each green sheet, raw materials were blended and mixed so that SiO₂ became 60.4 mol%, B₂O₃ 15.6 mol%, Al₂O₃ 6 mol%, CaO 15 mol%, K₂O 1 mol% and Na₂O 2 mol%, and this raw material mixture was put into a platinum crucible and melted at 1,600°C for 60 minutes. Then, this molten state glass was cast and cooled. This glass was ground by a ball mill made of alumina to obtain a glass powder. Here, ethyl alcohol was used as the solvent at the time of grinding.

35 mass% of this glass powder, 40 mass% of alumina filler (tradename: AL-45H manufactured by Showa Denko K.K.) and 25 mass% of zirconia filler (tradename: HSY-3F-J manufactured by Daiichi Kigenso Kagaku Kogyo Co., Ltd.) were blended and mixed to prepare a glass ceramics composition. To 50 g of this glass ceramics composition, 15 g of an organic solvent (a mixture of toluene, xylene, 2-propanol and 2-butanol in a mass ratio of 4:2:2:1), 2.5 g of a plasticizer (di-2-ethylhexyl phthalate), 5 g of polyvinyl butyral (tradename: PVK #3000K manufactured by DENKI KAGAKU KOGYO KABUSHIKI KAISHA) as a binder and a dispersing agent (tradename: BYK180 manufactured by BYK Japan KK) were blended and mixed to prepare a slurry.

This slurry was applied on a PET film by a doctor blade method, and dried to obtain a green sheet, and such green sheets were laminated to prepare a substantially flat plate-form green sheet 2 for base member which would have a thickness of 0.4 mm after firing, and a green sheet 3 for a frame member wherein the outer shape of the frame was the same as the green sheet 2 for base member, the shape in the frame was a substantially rectangular shape with a long side of 2.5 mm and a short side of 1.5 mm, and the frame height after firing would be 0.45 mm.

On the other hand, a conductive powder (tradename: S550 manufactured by Daiken Chemical Co., Ltd.) and ethylcellulose as a vehicle were blended in a mass ratio of 85:15 and dispersed in α- terpineol as a solvent so that the solid content would be 85 mass%. Then, kneading was carried out in a porcelain mortar for 1 hour, and further, dispersion was carried out three times by a three roll mill to prepare a wiring conductor paste.

Through-holes having a diameter of 0.3 mm were formed on the green sheet 2 for base member at portions corresponding to the pair of via conductors 7 by means of a punching machine and filled with the wiring conductor paste by a screen printing method to form via conductor paste layers 7, and at the same time, on the rear surface 23, a pair of external connection terminal conductor paste layers 6 were formed. Further, on the main surface 21 of the green sheet 2 for base member, a pair of substantially circular element connection terminal paste layers 5 were formed by a screen printing method to cover the via conductor paste layers 7, to obtain a green sheet 2 for base member provided with conductor paste layers.

On the main surface 21 of the green sheet 2 for base member provided with conductive paste layers, the green sheet 3 for frame member obtained as described above, was laminated to obtain a non-fired substrate 1 for light-emitting element. This non-fired substrate 1 for light-emitting element was subjected to binder burn out by holding it at 550°C for 5 hours, and further firing was carried out by holding it at 870°C for 30 minutes to prepare a substrate 1 for light-emitting element for test.

In the obtained substrate 1 for light-emitting element, a concave 4 having a side surface 25 constituted by the inner wall surface of the frame member 3 and a bottom surface 24 constituted by a part of the main surface 21 of the base member, had a substantially rectangular shape with a long side of 2.5 mm and a short side of 1.5 mm. Further, the side surface 25 of the concave 4 was formed to be substantially perpendicular to the bottom surface 24, and its height was 0.6 mm. The surface roughness Ra of the main surface 21 of the base member in the substrate 1 for light-emitting element was confirmed to be 0.01 µm by a measurement by means of SURFCOM 1400D manufactured by Tokyo Seimitsu Co., Ltd. Further, the haze value at the surface of the main surface of the base member and the inner wall surface of the frame member was measured by a haze meter (NDH2000 manufactured by Nippon Denshoku Industries Co., Ltd.) and found to be 100%.

On the mounting portion 22 of the substrate 1 for light-emitting element for test prepared as described above, one 2-wire type light-emitting diode element was mounted to prepare a light-emitting device10. Specifically, a light-emitting diode element 11 (tradename: GQ2CR460Z manufactured by Showa Denko K.K., size: 380 µm x 240 µm, height: 80 µm) was fixed to the above position (the position substantially at the center portion of the concave 4, where the long side of the concave 4 and the long side of the light emitting element 11 would be in the same direction) by a die bond material (tradename: KER-3000-M2 manufactured by Shin-Etsu Chemical Co., Ltd.), and a pair of electrodes of the light-emitting element 11 and the pair of element connection terminals 5 were respectively electrically connected via bonding wires 12. Here, the height of the highest portion of the mounted light-emitting element was 83 µm from the bottom surface 24 of the concave 4.

In the above light-emitting device 10, the distance from the inner wall surface of the frame member 3 i.e. the side surface 25 of the concave 4 to the edge of the light-emitting element 11 was 1,060 µm as the maximum value (the length corresponding to L2 in Fig. 1) and 630 µm as the minimum value (the length corresponding to L1 in Fig. 1).

Further, using a sealing material (tradename: SCR-1016A manufactured by Shin-Etsu Chemical Co., Ltd.), sealing was carried out to form a sealing layer 13 as shown in Fig. 3. As the sealing material, one containing a phosphor (tradename: P46-Y3 manufactured by Mitsubishi Chemical Holdings Corporation) in an amount of 20 mass% based on the sealing material, was used.

### COMPARATIVE EXAMPLE 1

A light-emitting device of Comparative Example 1 was prepared in the same manner as Example 1 except that in the above Example 1, a reflection film made of silver was provided on the inner wall surface of the frame member 3.

### COMPARATIVE EXAMPLE 2

A light-emitting device of Comparative Example 2 was prepared in the same manner as in Example 1 except that in the above Example 1, the frame member 3 was provided in such a shape that the angle between the side surface 25 and the bottom surface 24 of the concave 4 became 135°, and a reflection film made of silver was formed on the inner wall surface of the frame member 3.

### <Evaluation>

With respect to the light-emitting devices obtained in the above Example 1 and Comparative Examples 1 and 2, the total luminous flux and the thermal resistance were measured by the following methods.

### [Total luminous flux]

The measurement of the total luminous flux of the light-emitting device was carried out by using a LED total luminous flux-measuring device (tradename: SOLIDLAMBDA·CCD·LED·MONITOR·PLUS manufactured by Spectra Co-op). The integrating sphere was 6 inches, and as a voltage/current generator, R6243 manufactured ADVANTEST Corporation was used. Further, the measurement was carried out by applying 35 mA to the LED element.

### [Thermal resistance]

The thermal resistance of the substrate for light-emitting element in the light-emitting device was measured by using a thermal resistance-measuring device (tradename: TH-2167 manufactured by MINEKOONDENKI). Here, the applied electric current was 35 mA, and the current was applied until the voltage drop was saturated, whereupon the saturation temperature was calculated by the temperature coefficient led from the dropped voltage and the temperature-voltage drop properties of the light-emitting diode element, and the thermal resistance was obtained.

The results are shown in Table 1. Here, the results are shown by percentages when the total luminous flux and the thermal resistance in the light-emitting device of Comparative Example 1 were regarded as 100%.

**TABLE 1**

| | Total luminous flux (%) | Thermal resistance (%) |
|---|---|---|
| Comparative Example 1 | 100 | 100 |
| Comparative Example 2 | 115 | 100 |
| Example 1 | 115 | 100 |

### EXAMPLE 2

By the following process, a light-emitting device for test mounting four light-emitting elements in the same structure as shown in Fig. 7 was prepared. Here, in the same manner as above, the same symbols were used for the components before and after firing.

Firstly, a green sheet 2 for base member, a green sheet 3a for a lower frame member and a green sheet 3b for an upper frame member were prepared to prepare the base member 2 and the frame member 3 of the substrate 1 for light-emitting element. The slurry for forming each green sheet was prepared in the same manner as in the above Example 1.

This slurry was applied on a PET film by a doctor blade method and dried to obtain a green sheet. Such green sheets were laminated to prepare a substantially flat plate-form green sheet 2 for base member to have a thickness of 0.4 mm after firing, a green sheet 3a for lower frame member wherein the shape in the frame was substantially rectangular with a long side of 0.78 mm and a short side of 0.64 mm after firing, four through-holes were formed, and the frame height (the height from the overcoat glass layer on the bottom surface 24 of the concave which will be described hereinafter) after firing was 0.1 mm, and a green sheet 3b for upper frame member wherein the outer shape of the frame is the same as the green sheet 2 for base member, the shape in the frame is circular with a diameter of 4.3 mm, and the height of the frame (the height from the lower frame member 3a) after firing was 0.35 mm.

On the other hand, a wiring conductor paste was prepared in the same manner as in the above Example 1. Further, a metal paste for heat dissipation layer was prepared by blending a silver powder (tradename: S400-2 manufactured Daiken Chemical Co., Ltd.) and ethylcellulose as a vehicle in a mass ratio of 90:10, then dispersing the mixture in α-terpineol as a solvent so that the solid content would be 87 mass%, followed by kneading in a porcelain mortar for 1 hour, and further by dispersion three times by a three roll mill.

Through-holes having a diameter of 0.3 mm were formed in the green sheet 3a for lower frame member at portions corresponding to the pair of via conductors 7 by means of a driller, and filled with the wiring conductor paste by a screen printing method to form via conductor paste layers 7b, and substantially circular element connection terminal paste layers 5 were formed to cover the via conductor paste layers 7b at prescribed positions on the upper surface i.e. on the side opposite to the surface laminated on the green sheet 2 for base member.

Through-holes having a diameter of 0.3 mm were formed in the green sheet 2 for base member at portions corresponding to the pair of via conductors 7 by means of a driller and filled with the wiring conductor paste by a screen printing method to form via conductor paste layers 7a and at the same time, on the rear surface 23, external connection terminal conductor paste layers 6 were formed. Further, on the main surface 21 of the green sheet 2 for base member, a paste layer 8 for heat dissipation layer was formed so that the thickness after firing would be 15 µm, by screen printing at a region excluding the periphery of the main surface 21 of the green sheet 2 for base member and the portions where the above pair of via conductors 7a were provided and the vicinity around them. The surface roughness Ra of the heat dissipation layer 8 after firing was confirmed to be 0.08 µm by the measurement by means of SURFCOM 1400D manufactured by Tokyo Seimitsu Co., Ltd.

An overcoat glass paste layer 9 was formed thereon by a screen printing method so that the thickness after firing would be 20 µm, to cover the entirety including the edge of the above paste layer 8 for heat dissipation layer and to exclude the region where the above pair of via conductors 7a are formed and the vicinity around them, to obtain a green sheet 2 for the main body provided with the conductor paste layers and the overcoat glass paste layer. The surface roughness Ra of the overcoat glass layer 9 after firing was confirmed to be 0.01 µm from the measurement by SURFCOM 1400D manufactured by Tokyo Seimitsu Co., Ltd.

Here, the glass powder for glass film used for the preparation of the above overcoat glass paste was prepared as follows. Firstly, raw materials were blended and mixed so that SiO₂ became 81.6 mol%, B₂O₃ 16.6 mol% and K₂O 1.8 mol%, and this raw material mixture was put into a platinum crucible and melted at 1,600°C for 60 minutes. Then, this molten state glass was cast and cooled. This glass was ground by a ball mill made of alumina for from 8 to 60 hours to obtain the glass powder for glass film.

60 mass% of this glass powder for overcoat glass film and 40 mass% of a resin component (one containing ethylcellulose and α-terpineol in a mass ratio of 85:15) were blended and then kneaded in a porcelain mortar for 1 hour and further dispersed three times by a three roll mill to prepare an overcoat glass paste.

On the main surface 21 of the green sheet 2 for base member provided with the conductor paste layers and the overcoat glass paste layer, obtained as described above, the green sheet 3a for lower frame member provided with conductor paste layers was laminated so that the surface on which the element connection terminal paste layers 5 were formed, faced upward. Further, the green sheet 3b for upper frame member obtained as described above was laminated thereon to obtain a non-fired substrate 1 for light-emitting element. This non-fired substrate 1 for light-emitting element was subjected binder burn out by holding it at 550°C for 5 hours, and further, firing was carried out by holding it at 870°C for 30 minutes to prepare a substrate 1 for light-emitting element for test.

In the obtained substrate 1 for light-emitting element, in each of the four concaves 4, having a side surface 25 constituted by the inner wall surface of a through-hole of the lower frame member 3a and a bottom surface 24 constituted by a part of the main surface 21 of the base member, the shape of the bottom surface 24 was substantially rectangular with a long side of 0.78 mm and a short side of 0.64 mm. Further, the side surface 25 of each concave 4 was formed to be substantially perpendicular to the bottom surface 24, and its height was 0.1 mm as the height from the above overcoat glass layer 9. The surface roughness Ra of the main surface 21 of the base member in the substrate 1 for light-emitting element was confirmed to be 0.01 µm from the measurement by means of SURFCOM 1400D manufactured by Tokyo Seimitsu Co., Ltd. Further, the haze value at the surface of the main surface 21 of the base member and the inner wall surface of the lower frame member 3a was 100% as measured by a haze meter (NDH2000 manufactured by Nippon Denshoku Industries Co., Ltd.).

On each of four mounting portions 22 of the substrate 1 for light-emitting element for test prepared as described above, one 2-wire type light-emitting diode element was mounted in a total of four elements, to prepare a light-emitting device 10. Specifically, each of four light-emitting diode elements 11 (tradename: GQ2CR460Z manufactured by Showa Denko K.K., size: 380 µm x 240 µm, height: 80 µm) was fixed by a die bond material (tradename: KER-3000-M2, manufactured by Shin-Etsu Chemical Co., Ltd.) at the above-mentioned position (in each concave, the position substantially at the center portion of the concave 4, where the long side of the concave 4 and the long side of the light emitting element 11 would be in the same direction), and the electrodes of the four light-emitting elements 11 and the pair of element connection terminals 5 were electrically connected in series via bonding wires 12. Here, the height of the highest portion of the mounted light-emitting element was 83 µm from the overcoat glass layer 9 on the bottom surface 24 of the concave 4.

In the above light-emitting device 10, in each of the four concaves 4, the distance from the inner wall surface of the lower frame member 3a i.e. the side surface 25 of each concave 4 to the edge of the light-emitting element 11 was about 200 µm along the entire periphery of the light-emitting element 11.

Further, by using a sealing material (tradename: SCR-1016A manufactured by Shin-Etsu Chemical Co., Ltd.), sealing was carried out to form a sealing layer 13 as shown in Fig. 7. As the sealing material, one containing a phosphor (tradename: P46-Y3 manufactured by Mitsubishi Chemical Holdings Corporation) in an amount of 17 mass% based on the sealing material, was used.

### COMPARATIVE EXAMPLE 3

A light-emitting device of a conventional structure was prepared as Comparative Example 3 in the same manner as in Example 2 except that in the above Example 2, the lower frame member 3a was not provided, and the upper frame member 3b was provided on the base member 2 by changing the frame height (the height from the overcoat glass layer 9 on the bottom surface 24 of the concave) to be 0.45 mm.

### <Evaluation>

With respect to the light-emitting devices obtained in the above Example 2 and Comparative Example 3, the total luminous flux and the thermal resistance were measured by the above-described methods.

The results are shown in Table 2. Here, the results are shown by percentages when the total luminous flux and the thermal resistance in the conventional light-emitting device of Comparative Example 3 were regarded as 100%.

**TABLE 2**

| | Total luminous flux (%) | Thermal resistance (%) |
|---|---|---|
| Comparative Example 3 | 100 | 100 |
| Example 2 | 118 | 100 |

By the substrate tor light-emitting element of the present invention, despite its simple structure, it is possible to efficiently reflect light emitted in a direction other than the light extraction direction from a mounted light-emitting element to the light extraction direction at the substrate surface. Further, according to the present invention, by using the substrate for light-emitting element of the present invention with good light extraction efficiency, it becomes possible to provide a light-emitting device capable of emitting light with sufficiently high brightness. Such a light-emitting device of the present invention is useful as a backlight for e.g. mobile phones or liquid crystal displays, as illumination for automobiles or decorations, or as other light sources.
1: substrate for light-emitting element, 2: base member, 3: frame member, 4: concave, 5: element connection terminal, 6: external connection terminal, 7: via conductor, 8: heat dissipation layer, 9: overcoat glass layer, 10: light-emitting device, 11: light-emitting element, 12: bonding wire, 13: sealing layer, 21: main surface of base member, 22: light-emitting element-mounting portion, 23: rear surface of base member, 24: bottom surface of concave, 25: side surface of concave

The entire disclosure of Japanese Patent Application No. 2010-082645 filed on March 31, 2010 including specification, claims, drawings and summary is incorporated herein by reference in its entirety.

## Claims

1. A substrate for light-emitting element, which comprises a substantially flat-form base member made of a sintered product of a first glass ceramics composition comprising a glass powder and a ceramics filler, and a frame member bonded on an upper main surface of the base member, wherein a concave is formed to have a bottom surface constituted by a part of the upper main surface of the base member and a side surface constituted by an inner wall surface of the frame member, so that the bottom surface of the concave has a mounting portion for mounting a light-emitting element, and the frame member is made of a sintered product of a second glass ceramics composition comprising a glass powder and a ceramics filler, which has a diffuse reflectivity.

2. The substrate for light-emitting element according to Claim 1, wherein the side surface of the concave is provided to be substantially perpendicular to the bottom surface of the concave.

3. The substrate for light-emitting element according to Claim 1 or 2, wherein the base member is made of a sintered product of a second glass ceramics composition comprising a glass powder and a ceramics filler, which has a diffuse reflectivity.

4. The substrate for light-emitting element according to any one of Claims 1 to 3, wherein the ceramics filler contained in the second glass ceramics composition is a mixture of an alumina powder and a zirconia powder.

5. The substrate for light-emitting element according to any one of Claims 1 to 4, wherein the frame member is bonded on the upper main surface of the base member, so that the distance between the side surface of the concave and the edge of the mounting portion on the bottom surface of the concave is substantially equal along the entire periphery of the mounting portion.

6. The substrate for light-emitting element according to any one of Claims 1 to 5, which is a substrate for light-emitting element to mount a plurality of light-emitting elements, wherein the frame member is designed in such a shape as to form the above concave independently for every light-emitting element to be mounted.

7. The substrate for light-emitting element according to Claim 6, wherein the height of the frame member located between the adjacent mounting portions for the light-emitting elements is at least the same height as the highest portion of the light-emitting elements when such light-emitting elements are mounted, and at most a height having 50µm added to said same height.

8. A light-emitting device comprising the substrate for light-emitting element as defined in any one of Claims 1 to 7 and a light-emitting element mounted thereon.
